# EUROPÄISCHE PATENTANMELDUNG

(11) **EP 4 535 817 A1**
(43) Veröffentlichungstag der Anmeldung: **09.04.2025**
(21) Anmeldenummer: 24200150.1
(22) Anmeldetag: 13.09.2024
(51) Int. Cl.: H04Q 9/00

(54) **MESSSYSTEM UND VERFAHREN ZUR CHARAKTERISIERUNG EINES MEHRADRIGEN KABELS**

(30) Priorität: 06.10.2023 DE 102023127325
(71) Anmelder: Turck Holding GmbH, 58553 Halver (DE)
(72) Erfinder: Hartisch, Thomas, 08344 Grünhain-Beierfeld (DE); Wohlrab, Jürgen Daniel, 09419 Thum (DE)
(74) Vertreter: LBP Lemcke, Brommer & Partner Patentanwälte mbB

(57) **Zusammenfassung**

Messsystem (1) zur Charakterisierung eines mehradrigen Kabels (2), welches mindestens zwei Datenerfassungseinheiten (3, 4, 4b, 4c) und eine zentrale Verarbeitungseinheit (5) umfasst,
wobei die zwei Datenerfassungseinheiten (3, 4, 4b, 4c) jeweils dazu vorgesehen sind, um an einem endseitigen Anschluss (6, 7, 7b, 7c) mit dem Kabel (2) kontaktiert zu werden und dazu ausgebildet sind, zumindest in einem aktiven Zustand des Kabels (2), jeweils eine elektrische Messgröße an den endseitigen Anschlüssen (6, 7, 7b, 7c) zu erfassen,
und bei dem die Datenerfassungseinheiten (3, 4, 4b, 4c) und die zentrale Verarbeitungseinheit (5) jeweils ein Kommunikationsmodul (8, 9, 10) umfassen, wobei
die Kommunikationsmodule (8, 9, 9b, 9c) der Datenerfassungseinheiten (3, 4, 4b, 4c) dafür vorgesehen sind, um eine drahtlose Peripheral-Verbindung (11) zwischen den Datenerfassungseinheiten (3, 4, 4b, 4c) aufzubauen, um die jeweils erfasste Messgröße von einer der Datenerfassungseinheiten (3, 4, 4b, 4c) an die jeweils andere Datenerfassungseinheit (3, 4, 4b, 4c) zu übermitteln, und wobei
das Kommunikationsmodul (8, 9, 9b, 9c) zumindest einer der Datenerfassungseinheiten (3, 4, 4b, 4c) und das Kommunikationsmodul (10) der zentralen Verarbeitungseinheit (5) dafür vorgesehen sind, um eine einzige drahtlose Central-Verbindung (12) zwischen einer der beiden Datenerfassungseinheiten (3, 4, 4b, 4c) und der zentralen Verarbeitungseinheit (5) aufzubauen, um zumindest eine der erfassten Messgrößen an die zentrale Verarbeitungseinheit (5) zu übermitteln.

## Beschreibung

Die vorliegende Erfindung betrifft ein Messsystem und ein Verfahren zur Charakterisierung eines mehradrigen Kabels.

Mehradrige Kabel können in verschiedenen Anwendungen zur Übertragung von Daten und Signalen oder etwa zur Energieversorgung dienen. Bei den Adern eines solchen Kabels handelt es sich jeweils um einen oder mehrere elektrische Leiter, die typischerweise jeweils von einer Isolationsschicht umgeben sind. Dadurch ist es möglich, die Adern in engem Kontakt zueinander im Kern des Kabels anzuordnen und durch eine gemeinsame Mantelschicht vor äußeren Einflüssen zu schützen. Zur Verbindung des mehradrigen Kabels mit einer oder mehreren elektrischen Vorrichtungen ist das Kabel endseitig typischerweise mit Anschlüssen versehen.

Im Einsatz des mehradrigen Kabels ist es gewünscht, eine dauerhaft verlässliche Übertragbarkeit von Daten und Signalen sowie zuverlässige Energieversorgung sicherzustellen. Dies ist jedoch dadurch erschwert, dass die Komponenten des besagten Kabels, je nach Herkunft und Zustand der verwendeten Materialien unterschiedliche Qualitäten in Bezug auf ihre elektrischen Eigenschaften aufweisen können. Ebenso können sich die elektrischen Eigenschaften des Kabels infolge von Alterung verschlechtern und damit eine zuverlässige Übertragung von Daten und Signalen sowie Energieversorgung behindern. Insbesondere durch Umwelteinflüsse oder etwa mechanische Belastungen kann sich die Zuverlässigkeit des Kabels bei der Übertragung von Daten und Signalen oder der Energieversorgung verschlechtern.

Es besteht daher ein Bedarf danach, sicherstellen zu können, ob die Beschaffenheit des mehradrigen Kabels den bestehenden Anforderungen entspricht. Dementsprechend ist es eine Aufgabe der Erfindung, Mittel vorzuschlagen, mittels derer es möglich ist, die Beschaffenheit eines mehradrigen Kabels auf einfache und zuverlässige Weise überprüfen zu können.

Die Aufgabe wird gelöst mittels eines Messsystems zur Charakterisierung eines mehradrigen Kabels nach Anspruch 1 sowie einem Verfahren zur Charakterisierung eines mehradrigen Kabels nach Anspruch 13. Vorteilhafte Weiterbildungen sind jeweils Gegenstände abhängiger Ansprüche.

Das erfindungsgemäße Messsystem dient zur Charakterisierung eines mehradrigen Kabels und umfasst mindestens zwei Datenerfassungseinheiten und eine zentrale Verarbeitungseinheit. Die zwei Datenerfassungseinheiten sind jeweils dazu vorgesehen, um an einem endseitigen Anschluss mit dem Kabel kontaktiert zu werden und sind dazu ausgebildet, zumindest in einem aktiven Zustand des Kabels, jeweils mindestens eine elektrische Messgröße an den endseitigen Anschlüssen zu erfassen. Die Datenerfassungseinheiten und die zentrale Verarbeitungseinheit umfassen jeweils ein Kommunikationsmodul. Die Kommunikationsmodule der Datenerfassungseinheiten sind dafür vorgesehen, um eine drahtlose Peripheral-Verbindung zwischen den Datenerfassungseinheiten aufzubauen, um die jeweils erfasste Messgröße von einer der Datenerfassungseinheiten an die jeweils andere Datenerfassungseinheit zu übermitteln. Das Kommunikationsmodul zumindest einer der Datenerfassungseinheiten und das Kommunikationsmodul der zentralen Verarbeitungseinheit sind ferner dafür vorgesehen, um eine einzige drahtlose Central-Verbindung zwischen der jeweiligen Datenerfassungseinheit und der zentralen Verarbeitungseinheit aufzubauen, um zumindest eine der erfassten Messgrößen und/oder eine davon abhängige Größe an die zentrale Verarbeitungseinheit zu übermitteln.

Mittels des erfindungsgemäßen Messsystems ist es auf einfache Weise möglich, die elektrischen Eigenschaften eines mehradrigen Kabels bereits während seiner Herstellung zu ermitteln, um feststellen zu können, ob diese den gewünschten Anforderungen entsprechen. Ebenso ist es möglich, eine solche Charakterisierung während des Betriebs des Kabels durchzuführen.

Die Datenerfassungseinheiten können jeweils eine elektrische Schaltung umfassen, die zumindest einen Sensor und eine elektrische Steuereinheit, zum Beispiel einen Microcontroller, umfassen. Der Sensor kann hierbei mit zumindest einem Teil der Adern der mehradrigen Kabel elektrisch kontaktiert sein und dient dazu, eine elektrische Messgröße, vorzugsweise mehrere elektrische Messgrößen, zu erfassen. Die Steuereinheit kann dazu dienen, den Sensor mit elektrischer Energie zu versorgen und diesen zur Erfassung der elektrischen Messgröße zu steuern.

Im Rahmen der Erfindung sind die Datenerfassungseinheiten jeweils alleinstehend dazu ausgebildet, die mindestens eine elektrische Messgröße zu erfassen. In anderen Worten kann eine der Datenerfassungseinheiten eine erste Datenerfassungseinheit sein und die jeweils andere der Datenerfassungseinheiten eine zweite Datenerfassungseinheit. Die erste Datenerfassungseinheit ist hierbei dazu ausgebildet, an einem ersten Anschluss mindestens eine elektrische Messgröße, vorzugsweise mehrere elektrische Messgrößen, zu erfassen und die zweite Datenerfassungseinheit an einem zweiten Anschluss die elektrische Messgröße, vorzugsweise die mehreren elektrischen Messgrößen, zu erfassen. Insbesondere sind die elektrischen Messgrößen, welche an dem ersten und dem zweiten Anschluss jeweils erfasst werden, ihrer Art nach identisch. Allerdings können sich die Messgrößen betraglich oder durch ein anderes Charakteristikum voneinander unterscheiden, sodass es durch einen Abgleich der Messgrößen möglich ist, einen Rückschluss auf den Zustand des Kabels oder einer seiner Adern zu ziehen.

Die Erfindung ist grundsätzlich nicht darauf beschränkt, welche elektrische Messgröße mittels der Datenerfassungseinheiten ermittelbar ist. Der aktive Zustand des Kabels kann als ein Betriebszustand angesehen werden, bei dem mindestens eine der Adern stromdurchflossen ist oder ein Potential zwischen zwei der Adern anliegt. Der aktive Zustand kann beispielsweise durch den Betrieb des Kabels hervorgerufen werden, indem dieses zwischen einer elektrischen Energiequelle und einem Verbraucher angeschlossen wird. Ebenso ist denkbar, dass zumindest eine der Datenerfassungseinheiten dazu ausgebildet ist, den aktiven Zustand herbeizuführen, beispielsweise, indem eine Testspannung zwischen zwei der Adern angelegt wird.

In einem einfachen Ausführungsbeispiel sind die Datenerfassungseinheiten jeweils dazu ausgestaltet, um mit einer Versorgungsader und/oder einer Signalader und einer Bezugspotentialader der Kabel elektrisch kontaktiert zu werden, und eine Stromstärke in der Versorgungsader und/oder der Signalader und/oder der Bezugspotentialader und/oder eine Spannung zwischen der Versorgungsader und/oder der Signalader und der Bezugspotentialader zu messen. Durch Vergleich der jeweils gemessenen Größen an den endseitigen Anschlüssen des Kabels, kann zum Beispiel auf den ohmschen Widerstand mindestens einer der Adern geschlossen werden.

Die zentrale Verarbeitungseinheit kann als eine Recheneinheit angesehen werden, die dazu dient, die erfassten elektrischen Messgrößen, die durch zumindest eine der Datenerfassungseinheiten ermittelt wurde, auszuwerten.

Wie oben erläutert, ist es wesentlich für die Erfindung, dass die Datenerfassungseinheiten und die zentrale Verarbeitungseinheit jeweils ein Kommunikationsmodul umfassen. Hierbei kann es sich um Funk-Module handeln, mit denen es möglich ist, die zwei unterschiedlichen Arten von drahtlosen Verbindungen herzustellen, die im Rahmen der Erfindung als Peripheral-Verbindung und als Central-Verbindung bezeichnet sind. Die Peripheral-Verbindung kann als eine drahtlose Verbindung zwischen den Datenerfassungseinheiten angesehen werden, während die Central-Verbindung als eine drahtlose Verbindung zwischen nur einer der Datenerfassungseinheiten und der zentralen Verarbeitungseinheit angesehen werden kann.

Die Peripheral-Verbindung kann als eine sog. Master-Slave-Verbindung angesehen werden. Die Kommunikationsmodule der Datenerfassungseinheiten können jeweils in zwei Modi, also in einem Dual-Topology-Mode, operieren. Insbesondere sind die Kommunikationsmodule der Datenerfassungseinheiten für Multi-Central-Verbindungen vorgesehen, was bedeutet, dass eine Datenerfassungseinheit gleichzeitig eine zentrale und eine periphere Rolle einnehmen kann und auch mit mehreren zentralen Verarbeitungseinheiten gleichzeitig verbunden sein kann. Das Verbindungslimit einer Datenerfassungseinheit für die Gesamtzahl möglicher Verbindungen ist hierbei insbesondere unabhängig von der Rolle, in welcher die Datenerfassungseinheit fungierien kann.

In herkömmlichen Verbindungskonfigurationen von Drahtlosnetzwerken, die mehrere Datenerfassungseinheiten und eine zentrale Verarbeitungseinheit umfassen, ist es üblich, dass jede der Datenerfassungseinheiten zu erkennen gibt, dass sie für eine Verbindung bereitsteht und die zentrale Verarbeitungseinheit sich anschließend mit diesen Datenerfassungseinheiten verbindet. Allerdings ist die Gesamtanzahl an Datenerfassungseinheiten, die mit der zentralen Verarbeitungseinheit verbunden werden können, durch die verfügbare Anzahl von Verbindungsplätzen der zentralen Verarbeitungseinheit begrenzt. Erfindungsgemäß ist deshalb vorgesehen, dass die Datenerfassungseinheiten eine Peripheral-Verbindung zueinander aufbauen und die zentrale Verarbeitungseinheit nur eine einzige Central-Verbindung zu nur einer der Datenerfassungseinheiten des Messsystems aufbaut. Dadurch reduziert sich die Anzahl der erforderlichen Verbindungsplätze an der zentralen Verarbeitungseinheit gegenüber herkömmlichen Verbindungskonfigurationen um die Hälfte. Im Umkehrschluss ist es erfindungsgemäß also möglich, die doppelte Anzahl peripherer Datenerfassungseinheiten mit nur einer zentralen Verarbeitungseinheit zu betreiben, als es üblicherweise vorgesehen wäre.

Es liegt also im Rahmen der Erfindung, dass eine der Datenerfassungseinheiten eine elektrische Messgröße, vorzugsweise mehrere elektrische Messgrößen, erfasst und diese über die Peripheral-Verbindung an die jeweils andere Datenerfassungseinheit übermittelt oder umgekehrt. Gleichzeitig ist nur eine der Datenerfassungseinheiten mittels der Central-Verbindung mit der zentralen Verarbeitungseinheit verbunden und übermittelt dieser zumindest eine oder beide der erfassten Messgrößen und/oder eine davon abhängige Größe. Es liegt insbesondere also auch im Rahmen der Erfindung, dass die Messgrößen in zumindest einer der Datenerfassungseinheiten vorverarbeitet werden und erst anschließend an die zentrale Verarbeitungseinheit übermittelt werden.

Grundsätzlich ist die Erfindung nicht darauf beschränkt, welche der beiden Datenerfassungseinheiten dazu ausgebildet ist, die Central-Verbindung mit der zentralen Verarbeitungseinheit auszubilden. In anderen Worten können beide Datenerfassungseinheiten in der Lage sein, in eine Central-Verbindung mit der zentralen Verarbeitungseinheit zu treten. Es ist lediglich relevant, dass zu einem Zeitpunkt nur eine der beiden Datenerfassungseinheiten mit der zentralen Verarbeitungseinheit verbunden ist, sodass in dem Messsystem nur eine einzige Central-Verbindung besteht. Vorzugsweise ist das Messsystem derart ausgebildet, dass die zentrale Verarbeitungseinheit die Central-Verbindung zu einer der Datenerfassungseinheiten aufbaut und nicht umgekehrt.

In einer vorteilhaften Weiterbildung sind die Kommunikationsmodule der Datenerfassungseinheiten und der zentralen Verarbeitungseinheit jeweils Bluetooth-Module, insbesondere Bluetooth-Low-Energy-Module.

Im Rahmen der vorstehend beschriebenen Weiterbildung ist ein Bluetooth-Modul eine Hardwarekomponente, die es ermöglicht, drahtlose Kommunikation mittels des drahtlosen Kommunikationsstandard "Bluetooth" herzustellen, um Daten zu übertragen. Sofern die Datenerfassungseinheiten einen Sensor und eine elektrische Steuereinheit umfassen, können die Bluetooth-Module mittels der jeweiligen elektrischen Steuereinheit mit elektrischer Energie versorgt und gesteuert werden.

Wie oben beschrieben, kann es sich bei den Bluetooth-Modulen um ein Bluetooth-Low-Energy-Module handeln, die über ein Bluetooth-Low-Energy-Protokoll miteinander kommunizieren. Hierbei handelt es sich um eine Variante des Bluetooth-Protokolls, die es ermöglicht, den Energiebedarf der Datenerfassungseinheiten und insbesondere derer Kommunikationsmodule, zu minimieren. Weitere Vorteile der Bluetooth-Low-Energy-Module sind kleine Datenpakete sowie ein schneller Verbindungsaufbau zwischen den Kommunikationsmodulen.

Insbesondere können die Datenerfassungseinheiten jeweils einen eigenen elektrischen Energiespeicher aufweisen, zum Beispiel eine elektrische Batterie oder einen elektrischen Akkumulator. Durch den Einsatz von Bluetooth-Low-Energy-Modulen als Kommunikationsmodule kann deren Energiebedarf, wie oben erläutert, verringert werden, wodurch eine verlängerte Laufzeit ermöglicht ist.

In einer vorteilhaften Weiterbildung sind die Datenerfassungseinheiten jeweils in einem der endseitigen Anschlüsse integriert und die Anschlüsse dafür vorgesehen, um mit zumindest zwei, vorzugsweise zumindest drei, insbesondere zumindest vier Adern des Kabels verbunden zu werden. Insbesondere umfasst das Messsystem auch die endseitigen Anschlüsse.

Ein Vorteil der vorstehend beschriebenen Weiterbildung besteht in einem hohen Maß an Funktionsintegration. Dies begründet sich dadurch, dass sowohl die elektrische Kontaktierung der mehradrigen Kabel als auch die Erfassung der elektrischen Messgrößen an den Anschlüssen sowie die Übertragung der elektrischen Messgrößen jeweils durch eine einzelne technische Komponente realisiert werden kann. Insbesondere kann der Montageaufwand für die Herstellung eines mehradrigen Kabels verringert werden, da die elektrische Kontaktierung der Anschlüsse und die Anordnung der Datenerfassungseinheiten in nur einem Montageschritt erfolgen können. Darüber hinaus kann der Zustand des Kabels auch nach seiner Auslieferung und im Betrieb zeitweise oder sogar dauerhaft überwacht werden.

In einer vorteilhaften Weiterbildung umfasst einer der endseitigen Anschlüsse einen Stecker und der jeweils andere endseitige Anschluss eine Buchse.

Der Stecker kann als männliches Anschlusselement für das mehradrige Kabel angesehen werden, welches nach außen weisende Kontaktelemente, insbesondere Kontaktstifte aufweist. Die Buchse kann als weibliches Anschlusselement für das mehradrige Kabel angesehen werden, das ein Gehäuse mit einer oder mehreren Kontaktflächen oder -öffnungen aufweist und dazu dient, in elektrische Verbindung mit den Kontaktelementen eines Steckers zu treten. Es liegt im Rahmen der vorteilhaften Weiterbildung, dass der Stecker und die Buchse zueinander korrespondierend ausgebildet sind. Alternativ können Stecker und Buchse jeweils nicht zueinander korrespondierend ausgebildet sein, je nachdem welche elektrischen Vorrichtungen sie miteinander verbinden sollen.

In einer vorteilhaften Weiterbildung sind die Datenerfassungseinheiten jeweils dazu ausgestaltet, um mit einer Versorgungsader und/oder einer Signalader und/oder einer Bezugspotentialader des Kabels elektrisch kontaktiert zu werden sowie dazu, eine Stromstärke in der Versorgungsader und/oder der Signalader und/oder der Bezugspotentialader und/oder eine Spannung zwischen der Versorgungsader und der Bezugspotentialader bzw. zwischen der Signalader und der Bezugspotentialader zu messen.

Die Versorgungsader und Bezugspotentialader können für eine elektrische Energie- und Leistungsübertragung zwischen einer elektrischen Energiequelle und einem Verbraucher dienen. Durch Messung der Stromstärke und/oder der Spannung kann mittels der Datenerfassungseinheiten auf die elektrischen Eigenschaften des Kabels geschlossen werden. Insbesondere kann ermittelt werden, ob und inwieweit die Eignung des Kabels zur Übertragung elektrischer Energie und Leistung beeinträchtigt ist. Die Signalader kann zur Übertragung eines oder mehrere Signale dienen, wobei die Signale beispielsweise als Spannungssignal oder als Stromsignal vorliegen können.

In einer vorteilhaften Weiterbildung sind die Datenerfassungseinheiten jeweils dazu ausgestaltet, um mit mindestens einer Signalader elektrisch kontaktiert zu werden und eine Signalcharakteristik in der Signalader, insbesondere eines Bus-Signals, zu erfassen.

Die Signalader dient der Übertragung eines oder mehrerer Signale zwischen den endseitigen Anschlüssen des Kabels. Das Signal kann hierbei als Spannungssignal und/oder Stromsignal vorliegen. Die Datenerfassungseinheiten können dazu eingerichtet sein, eine Amplitude, eine Frequenz, eine Phasenverschiebung, eine Anstiegszeit, eine Abfallzeit, eine Signalverzerrung und/oder ein Rauschen des Signals zu erfassen. Insbesondere können die Datenerfassungseinheiten dazu ausgebildet sein, ein Referenzsignal zu senden und zu empfangen, anhand dessen, die Signalcharakteristik bewertet wird.

In einer vorteilhaften Weiterbildung weisen die Datenerfassungseinheiten und/oder die zentrale Verarbeitungseinheit jeweils ein Speichermodul auf, auf welchem zumindest eine Identifikationskennung, insbesondere eine Media-Access-Control (MAC)-ID gespeichert ist, und über welche die Datenerfassungseinheiten für die drahtlose Peripheral-Verbindung einander zugeordnet sind und/oder über welche zumindest eine der Datenerfassungseinheiten der zentralen Verarbeitungseinheit für die drahtlose Central-Verbindung zugeordnet ist.

Die Identifikationskennung dient im Rahmen der vorteilhaften Weiterbildung dazu, eine eindeutige Zuordnung zwischen den Datenerfassungseinheiten bzw. zwischen der zentralen Verarbeitungseinheit und einer der Datenerfassungseinheiten sicherzustellen. Dies ist insbesondere dann von Vorteil, wenn sich mehr als nur die zwei Datenerfassungseinheit des Messsystems in ausreichender Nähe zueinander oder zu der zentralen Verarbeitungseinheit befinden, sodass grundsätzlich mehrere drahtlose Datenverbindungen herstellbar sind. Dies kann während der Herstellung eines mehradrigen Kabels, insbesondere bei dessen Montage mit einem erfindungsgemäßen Messsystem, der Fall sein oder auch im späteren Betrieb.

In einer vorteilhaften Weiterbildung weist zumindest eine der Datenerfassungseinheiten ein Auswertungsmodul auf, welches dazu eingerichtet ist, um die an den beiden endseitigen Anschlüssen erfassten Messgrößen zu verarbeiten und eine davon abhängige Größe an die zentrale Verarbeitungseinheit zu übermitteln.

In einem einfachen Ausführungsbeispiel kann das Auswertungsmodul ein elektrischer Controller, insbesondere ein Microcontroller, sein, welcher die gemessenen Messgrößen vorverarbeiten kann. Ferner kann es sich bei dem Auswertungsmodul um die elektrische Steuereinheit handeln, die auch zur Steuerung des jeweiligen Sensors dient. Die Verarbeitung der Messgrößen kann auf unterschiedliche Weisen erfolgen und beispielsweise eine Filterung, eine Differenz-, Quotienten- oder Mittelwertbildung, eine Transformation, insbesondere eine Fourier-Transformation, eine Datenkompression, eine Messwertglättung oder Interpolation oder etwa eine Signalverstärkung umfassen.

Mittels Filterung kann unerwünschtes Rauschen reduziert oder bestimmte Frequenzbereiche isoliert werden. Es stehen verschiedene digitale Filtertypen wie Tiefpass-, Hochpass-, Bandpass- und Notch-Filter zur Verfügung. Mittels Mittelwertbildung, Quotientenbildung oder Differenzbildung können aus den Messgrößen einfach zu interpretierende Kenngrößen berechnet werden. Die Fourier-Transformation, insbesondere die schnelle Fourier-Transformation (FFT), ermöglicht es der elektrischen Steuereinheit, Signale aus dem Zeitbereich in den Frequenzbereich zu transformieren. Dadurch können spezifische Frequenzkomponenten identifiziert und die Spektralanalyse durchgeführt werden. In Anwendungen mit begrenztem Speicher kann mittels Datenkompression eine vorliegende Datenmenge reduziert werden und Informationen effizienter gespeichert und übertragen werden.

Insbesondere umfasst die abhängige Größe einen zeitlichen Verlauf zumindest einer der Messgrößen. Insbesondere kann der zeitliche Verlauf eine Mehrzahl an diskreten Messpunkten umfassen, denen jeweils ein Messzeitpunkt zugeordnet ist. Ebenso ist es möglich, dass das Auswertungsmodul dazu ausgestaltet ist, den diskreten zeitlichen Verlauf mittels Interpolation oder einer vergleichbaren Methode in einen zumindest teilweise kontinuierlichen Verlauf zu konvertieren.

Anhand des zeitlichen Verlaufs der Messgröße ist es möglich, eine Signallaufzeit zu ermitteln, indem ein Signal mittels der Datenerfassungseinheiten erfasst wird und die Messzeitpunkte miteinander verglichen werden. Ebenso ist es möglich, daraus eine Kabellänge zu ermitteln oder zumindest abzuschätzen.

Ebenso kann anhand des zeitlichen Verlaufs der Messgröße eine Kabelimpedanz ermittelt werden. Die Kabelimpedanz ist ein wichtiger Parameter, welcher den Einfluss auf die Signalqualität infolge der Beschaffenheit des Kabels angibt. Die Kabelimpedanz kann als ein Wechselstromwiderstand angesehen werden und dabei durch das Verhältnis der zeitlichen Verläufe zwischen Spannung und Strom definiert sein. Insbesondere sind die Datenerfassungseinheiten vorzugsweise jeweils dazu ausgebildet, eine Stromstärke und/oder eine Spannung derart zu erfassen, dass aus ihren zeitlichen Verläufen die Kabelimpedanz ermittelt werden kann.

In einer vorteilhaften Weiterbildung umfasst das Messystem zumindest drei Datenerfassungseinheiten, die jeweils dafür vorgesehen sind, um an den endseitigen Anschlüssen eines mehradrigen Y-Kabels kontaktiert zu werden, und welche jeweils dazu ausgebildet sind, um zumindest in einem aktiven Zustand des Y-Kabels eine elektrische Messgröße, vorzugsweise mehrere elektrische Messgrößen an einem der endseitigen Anschlüsse zu erfassen. Die Datenerfassungseinheiten umfassen jeweils ein Kommunikationsmodul. Die Kommunikationsmodule der Datenerfassungseinheiten sind jeweils dafür vorgesehen, um zwei drahtlose Peripheral-Verbindungen zwischen jeweils zwei der drei Datenerfassungseinheiten aufzubauen. Das Kommunikationsmodul zumindest einer der drei Datenerfassungseinheiten ist auch dazu ausgebildet, um eine einzige drahtlose Central-Verbindung mit dem Kommunikationsmodul der zentralen Verarbeitungseinheit aufzubauen.

Es ist ein Vorteil der vorstehend beschriebenen vorteilhaften Weiterbildung, dass mehrere Peripheral-Verbindungen zwischen drei Datenerfassungseinheiten ausgebildet werden können, um ein mehradriges Y-Kabel zu charakterisieren.

Ein mehradriges Y-Kabel ist eine Art eines elektrischen Kabels, das einen einzelnen Stammabschnitt umfasst, der sich in zwei Astabschnitte aufteilt. Diese Art von Kabel wird häufig in Stromversorgungs- oder Verteilungssystemen eingesetzt, um Informationen oder elektrische Energie von einem zentralen Punkt zu mehreren Verbrauchern oder Geräten zu übertragen oder umgekehrt.

Es ist ein Vorteil, dass auch für die Charakterisierung eines Y-Kabels lediglich eine Central-Verbindung zwischen einer der drei Datenerfassungseinheiten und der zentralen Verarbeitungseinheit erforderlich ist, wobei es grundsätzlich unerheblich ist, zu welcher der drei Datenerfassungseinheiten die zentrale Verarbeitungseinheit die Central-Verbindung aufbaut. Darüber hinaus ist die vorteilhafte Weiterbildung nicht darauf beschränkt, zwischen welchen Datenerfassungseinheiten die zwei Peripheral-Verbindungen aufgebaut werden.

So kann das Messsystem in einer ersten Verbindungskonfiguration eine von drei Datenerfassungseinheit aufweisen, welche über eine Central-Verbindung mit der zentralen Verarbeitungseinheit und gleichzeitig über zwei Peripheral-Verbindungen mit den beiden anderen Datenerfassungseinheiten verbunden ist.

In einer zweiten Verbindungskonfiguration weist das Messsystem ebenfalls eine erste von drei Datenerfassungseinheiten auf, welche über eine Central-Verbindung mit der zentralen Verarbeitungseinheit und gleichzeitig über eine erste Peripheral-Verbindung mit einer zweiten der drei Datenerfassungseinheiten verbunden ist. Die zweite Datenerfassungseinheit ist ihrerseits wiederum über eine zweite Peripheral-Verbindung mit einer dritten Datenerfassungseinheit verbunden.

Es liegt im Rahmen der vorteilhaften Weiterbildung, dass die Verbindungskonfiguration veränderlich ist, zumindest zwischen der oben beschriebenen ersten und zweiten Verbindungskonfiguration.

Wie oben erläutert, wird die Aufgabe auch gelöst durch ein Verfahren zur Charakterisierung eines mehradrigen Kabels. Das erfindungsgemäße Verfahren umfasst die folgenden Verfahrensschritte:
A) Bereitstellen eines erfindungsgemäßen Messsystems oder einer vorteilhaften Weiterbildung davon sowie eines mehradrigen Kabels;
B) Elektrisches Kontaktieren der mindestens zwei Datenerfassungseinheiten mit dem Kabel über jeweils einen endseitigen Anschluss;
C) Anlegen einer elektrischen Spannung an das Kabel;
D) Aufbauen einer drahtlosen Peripheral-Verbindung zwischen den Datenerfassungseinheiten des Messsystems;
E) Aufbauen einer einzigen drahtlosen Central-Verbindung zwischen der zentralen Verarbeitungseinheit mit nur einer der Datenerfassungseinheiten;
F) Erfassen zumindest zweier elektrischer Messgrößen an den Anschlüssen mittels der Datenerfassungseinheiten;
G) Übermitteln zumindest einer der erfassten Messgrößen zwischen den Datenerfassungseinheiten über die Periperal-Verbindung;
H) Übertragen zumindest einer der erfassten Messgrößen und/oder einer davon abhängigen Größe von einer der Datenerfassungseinheiten an die zentrale Verarbeitungseinheit über die Central-Verbindung.

Das erfindungsgemäße Verfahren ist vorgesehen, um mittels eines erfindungsgemäßen Messsystems oder einer vorteilhaften Weiterbildung davon durchgeführt zu werden. Insofern gelten die Ausführungen bezüglich der mit dem Messsystem erreichbaren Vorteile entsprechend. Insbesondere kann die in Verfahrensschritt H) übertragene Messgröße vorverarbeitet sein oder eine daraus abgeleitete Größe übermittelt werden.

In einer vorteilhaften Weiterbildung, erfolgt in Verfahrensschritt D) ein Advertising zwischen den Kommunikationsmodulen der Datenerfassungseinheiten.

Im Rahmen der vorteilhaften Weiterbildung kann "Advertising" als ein Vorgang verstanden werden, bei dem die Kommunikationsmodule Informationen über sich selbst an andere Kommunikationsmodule in ihrer Umgebung senden. Dieser Vorgang ist auch als "Beaconing" bekannt. Das Ziel des Advertisings ist es, anderen Geräten ihre Anwesenheit, verfügbare Dienste oder Datenpakete mitzuteilen, ohne dass eine direkte Verbindung hergestellt werden muss. Für den Fall, dass die Kommunikationsmodule als Bluetooth-Module oder insbesondere Bluetooth-Low-Energy-Module ausgebildet sind, ist das Advertising ein wichtiger Teil des entsprechenden Bluetooth-Protokolls, welcher es Bluetooth-Geräten ermöglicht, in einem stromsparenden Zustand zu bleiben und nur kurzzeitig ihre Präsenz und Daten an andere Geräte zu kommunizieren.

Mittels Advertising können Informationen der Datenerfassungseinheit, wie etwa Gerätebezeichnung oder benutzerdefinierte Daten übertragen werden. Diese Informationen können von mindestens einer anderen Datenerfassungseinheit erfasst und dazu verwendet werden, um eine Verbindung zu dem werbenden Gerät herzustellen. Es könnten optional auch weitere Daten mittels Advertising übermittelt werden und beispielsweise zusätzliche Informationen oder Details enthalten, die auf eine spezifische Anfrage hin gesendet werden. Es ist eine Möglichkeit für das werbende Gerät, erst bei Bedarf mehr Informationen bereitzustellen, ohne die Länge eines initialen Advertising-Pakets zu erhöhen.

In einer vorteilhaften Weiterbildung gibt nach Verfahrensschritt D) eine der Datenerfassungseinheiten ein Advertising-Zeitfenster an die jeweils andere Datenerfassungseinheit, wobei im Falle eines Verbindungsabbruchs zwischen einer der Datenerfassungseinheiten und der zentralen Verarbeitungseinheit und bei Überschreitung des Advertising-Zeitfensters die zentrale Verarbeitungseinheit eine drahtlose Central-Verbindung mit der jeweils anderen Datenerfassungseinheit aufbaut. Auf diese Weise ist es möglich, sicherzustellen, dass stets nur eine Central-Verbindung aufgebaut ist.

Insbesondere können die zwei Datenerfassungseinheiten einen Token, so lange austauschen, bis die zentrale Verarbeitungseinheit eine drahtlose Verbindung mit der einer der Datenerfassungseinheiten aufgebaut hat. Der Token kann hierbei als eine Zeichenfolge oder ein vergleichbares Identifikationsmerkmal angesehen werden, welcher nur von derjenigen Datenerfassungseinheit gespeichert werden kann, welche über die Central-Verbindung mit der zentralen Verarbeitungseinheit verbunden ist oder mit der eine solche Central-Verbindung aufgebaut werden soll. Es liegt auch im Rahmen der Weiterbildung, dass der Token immer nur von derjenigen Datenerfassungseinheit gespeichert ist, welche die Central-Verbindung nicht aufbauen soll.

In einer vorteilhaften Weiterbildung erfolgt in Verfahrensschritt E) ein Advertising zwischen mindestens einem der Kommunikationsmodule der Datenerfassungseinheiten und dem Kommunikationsmodul der zentralen Verarbeitungseinheit. Insbesondere ist es mittels des Advertisings zwischen mindestens einem der Kommunikationsmodule der Datenerfassungseinheiten und dem Kommunikationsmodul der zentralen Verarbeitungseinheit möglich, noch vor Aufbau der Central-Verbindung zu ermitteln, welche der Datenerfassungseinheiten mit einer besseren Verbindungsqualität einhergeht.

In einer vorteilhaften Weiterbildung wird in Verfahrensschritt E) mittels der zentralen Verarbeitungseinheit mindestens einer der beiden Datenerfassungseinheiten ein Received Signal Strength Indicator (RSSI)-Wert zugeordnet und gespeichert.

Der RSSI-Wert kann als eine Empfangs-Signalstärke angesehen werden. Es ist ein Messwert, der die Stärke eines empfangenen Signals einer drahtlosen Datenverbindung, insbesondere mittels Bluetooth, angibt. Der RSSI-Wert wird üblicherweise in Dezibel (dBm) ausgedrückt und zeigt die Leistung des empfangenen Signals relativ zur Referenzleistung (1 Milliwatt) an. Je höher der RSSI-Wert ist, desto stärker ist das empfangene Signal. Ein niedriger RSSI-Wert hingegen deutet auf eine schwache Signalstärke hin.

In einer vorteilhaften Weiterbildung wird mittels der zentralen Verarbeitungseinheit den beiden Datenerfassungseinheiten jeweils ein Received Signal Strength Indicator (RSSI)-Wert zugeordnet und gespeichert und die Central-Verbindung zwischen der zentralen Verarbeitungseinheit und derjenigen Datenerfassungseinheit aufgebaut, welcher der höhere Received Signal Strength Indicator (RSSI)-Wert zugeordnet ist. Dadurch wird sichergestellt, dass die drahtlose Central-Verbindung mit derjenigen Datenerfassungseinheit hergestellt wird, die mit der besseren Signalqualität einhergeht, was in der Regel zu einer zuverlässigeren und leistungsfähigeren Verbindung führt. Dies kann besonders nützlich sein, um die Qualität der drahtlosen Kommunikation in Umgebungen mit schwachen Signalen oder Interferenzen zu verbessern.

Vorteile der Erfindung sind nachfolgend anhand von Ausführungsbeispielen und den Figuren erläutert.

Es zeigen
- Figur 1: ein mehradriges Kabel mit einem Messsystem;
- Figur 2: eine Verbindungskonfiguration des Messsystems;
- Figur 3: einen beispielhaften Pin-Belegungsplan zweier Datenerfassungseinheiten des Messsystems mit den Adern des mehradrigen Kabels;
- Figur 4: ein mehradriges Y-Kabel mit einem Messsystem.

Mehradrige Kabel werden häufig zur Signal- und Energieübertragung in elektronischen und elektrischen Systemen eingesetzt. Ein solches Kabel umfasst häufig mehrere voneinander isolierte Adern, die räumlich gebündelt und von einem gemeinsamen Mantel umschlossen sind. Für die Signalübertragung werden die Adern verwendet, um Daten und Informationen zwischen verschiedenen Komponenten zu übertragen. Für die Energieübertragung können die mehradrigen Kabel dazu verwendet werden, elektrische Energie von einer Stromquelle zu einem Verbraucher, etwa einem Sensor oder Motor oder einem vergleichbaren elektrischen Gerät zu übertragen.

Da mehradrige Kabel eine wichtige Rolle bei der Signal- und Energieübertragung spielen, ist es häufig erforderlich, überprüfen zu können, ob das Kabel die gewünschte Qualität aufweist.

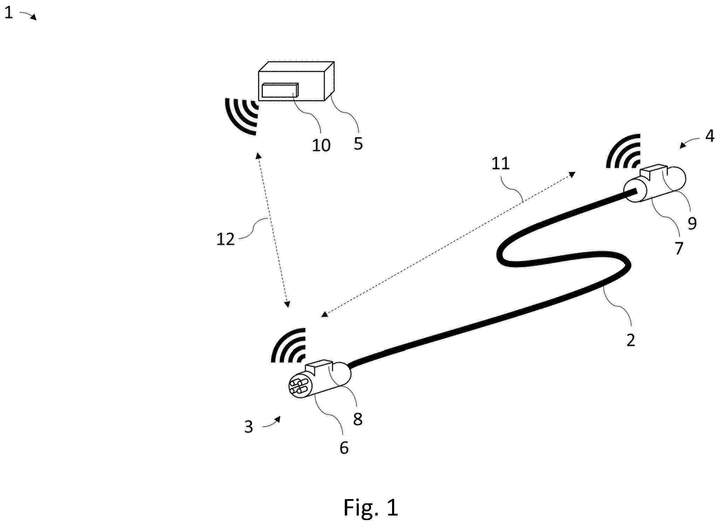

Figur 1 zeigt ein Messsystem 1, welches zur Charakterisierung eines Kabels 2 mit insgesamt vier Adern dient und dafür zwei Datenerfassungseinheiten 3 und 4 sowie eine zentrale Verarbeitungseinheit 5 aufweist.

Die Datenerfassungseinheiten 3 und 4 sind in die Anschlüsse 6 bzw. 7 integriert, die endseitig mit dem Kabel 2 verbunden sind. Anschluss 6 ist hierbei als Stecker mit nach außen ragenden Kontaktelementen ausgebildet, während Anschluss 7 in nicht näher gezeigter Weise als Buchse ausgebildet ist.

Die Datenerfassungseinheiten 3 und 4 dienen im aktiven Zustand des Kabels 2 dazu, jeweils eine elektrische Messgröße an den endseitigen Anschlüssen 6 bzw. 7 zu erfassen. Der aktive Zustand bezeichnet in dem in Figur 1 gezeigten Ausführungsbeispiel einen Zustand, in dem zwischen einer der Adern und der Bezugspotentialader des Kabels 2 eine elektrische Spannung anliegt. Die Spannung kann hierbei zur Spannungsversorgung einer Komponente dienen, die mittels des Kabels 2 kontaktiert ist oder etwa ein elektrisches Signal zur Steuerung besagter Komponente sein.

Die Datenerfassungseinheiten 3 und 4 sind dazu ausgebildet, jeweils eine elektrische Messgröße zwischen einer der Adern und der Bezugspotentialader zu messen. Konkret dient die Datenerfassungseinheit 3 dazu, eine erste Spannung am Anschluss 6 zu messen und die jeweils andere Datenerfassungseinheit 4 dazu, eine zweite Spannung am Anschluss 7 zu messen. Wird mittels der Datenerfassungseinheiten 3 und 4 festgestellt, dass die erste und zweite Spannung zwischen den Anschlüssen 6 und 7 sich voneinander betraglich unterscheiden, kann etwa darauf geschlossen werden, dass ein ohmscher Widerstand in dem Kabel 2 übermäßig hoch ist. Die Messung der Spannungen an den Anschlüssen kann hierbei mit einer einstellbaren Abtastrate über einen ebenfalls einstellbaren Zeitraum erfolgen, insbesondere um den aktiven Zustand des Kabels 2 dauerhaft überwachen zu können.

Eine Besonderheit des in Figur 1 gezeigten Messsystems 1 besteht darin, dass die Kommunikationsmodule 8 und 9, welche den Datenerfassungseinheiten 3 bzw. 4 zugeordnet sind, dazu vorgesehen sind, eine periphere Drahtlosverbindung 11 (auch: Peripheral-Verbindung) zwischen den Datenerfassungseinheiten 3 und 4 herzustellen, während gleichzeitig das Kommunikationsmodul 8 oder 9 einer der Datenerfassungseinheiten 3 oder 4 dazu dient, nur eine einzelne, zentrale Drahtlosverbindung 12 (auch: Central-Verbindung) zu der zentralen Verarbeitungseinheit 10 aufzubauen.

Es ist zu einem Zeitpunkt im Betrieb des Messsystems 1 also nur eine Central-Verbindung 12 zwischen der zentralen Verarbeitungseinheit 5 und einer der Datenerfassungseinheiten 3 oder 4 vorgesehen. Dies ermöglicht eine optimale Ausnutzung aller zur Verfügung stehender Verbindungspunkte der zentralen Verarbeitungseinheit 5. Insbesondere werden gemäß dem in Figur 1 gezeigten Messsystem 1 nicht gleichzeitig zwei Central-Verbindungen zwischen der zentralen Verarbeitungseinheit 5 und jeweils einer der zwei Datenerfassungseinheiten 3 bzw. 4 aufgebaut, wie es in vergleichbaren drahtlosen Kommunikationsnetzwerken üblicherweise vorgesehen wäre. Daher lässt sich die Anzahl an erforderlichen zentralen Verarbeitungseinheiten 5 bei gleicher Anzahl an Datenerfassungseinheiten 3, 4 verringern bzw. die Anzahl an verwendbaren Datenerfassungseinheiten 3, 4 bei nur einer verwendeten zentralen Verarbeitungseinheit 5 erhöhen.

Bei den Kommunikationsmodulen 8, 9 und 10 handelt es sich in dem gemäß Figur 1 gezeigten Ausführungsbeispiel um Bluetooth-Low-Energy-Module. Diese kommunizieren über ein Bluetooth-Low-Energy-Protokoll miteinander. Hierbei handelt es sich um eine Variante des Bluetooth-Protokolls, die es ermöglicht, den Energiebedarf der Datenerfassungseinheiten zu minimieren. Dies wird unter anderem durch kleine Datenpakete erreicht sowie einen schnellen Verbindungsaufbau zwischen den Kommunikationsmodulen 8, 9, 10.

Die Datenerfassungseinheiten 3, 4 weisen in hier nicht näher gezeigter Weise jeweils ein Speichermodul auf, auf denen jeweils eine Identifikationskennung in Gestalt einer Media-Access-Control (MAC)-ID, gespeichert sind, welche der jeweils anderen Datenerfassungseinheit 3, 4 zugeordnet sind. Dadurch ist es den Datenerfassungseinheiten 3, 4 möglich, während eines Advertising-Vorgangs einander als Kommunikationspartner zu identifizieren und die Peripheral-Verbindung 11 aufzubauen.

Nach Herstellung der Peripheral-Verbindung 11 tauschen die zwei Datenerfassungseinheiten 3 und 4 einen Token so lange aus, bis die zentrale Verarbeitungseinheit 5 die drahtlose Central-Verbindung 12 mit einer der Datenerfassungseinheiten 3, 4 aufgebaut hat. Bei dem Token handelt es sich um eine Zeichenfolge, welche von derjenigen Datenerfassungseinheit gespeichert wird, mit der die zentrale Verarbeitungseinheit 5 die Central-Verbindung 12 aufbauen soll. Dadurch wird sichergestellt, dass nicht beide Datenerfassungseinheiten 3, 4 gleichzeitig eine Central-Verbindung 12 zu der zentralen Verarbeitungseinheit 5 aufbauen.

Bei einem Verbindungsabbruch der Central-Verbindung 12 erhält die jeweils andere Datenerfassungseinheit 3, 4 den Token und die zentrale Verarbeitungseinheit 5 baut die drahtlose Central-Verbindung 12 mit dieser Datenerfassungseinheit 3, 4auf. Hierbei wird durch die Datenerfassungseinheiten jeweils ein Zeitfenster berücksichtigt, innerhalb dessen die Central-Verbindung 12 aufgebaut sein muss, bevor die jeweils andere Datenerfassungseinheit 3, 4 den Token wieder zurückerhält und die zentrale Verarbeitungseinheit 5 versucht, mit dieser Datenerfassungseinheit 3,4 die Central-Verbindung 12 aufzubauen.

Die Datenerfassungseinheiten 3, 4 weisen jeweils ein Auswertungsmodul (nicht gezeigt) auf, welches jeweils dazu eingerichtet ist, um die an den beiden endseitigen Anschlüssen 6, 7 erfassten Messgrößen, also die elektrischen Spannungen, zu verarbeiten und eine davon abhängige Größe zu ermitteln, damit diese an die zentrale Verarbeitungseinheit 5 übermittelt werden kann. Bei der abhängigen Größe handelt es sich um eine Differenz zwischen den Spannungen an den Anschlüssen 6, 7. Dadurch ist es möglich zusammen mit der dazugehörigen Stromstärke, welche für die betreffende Ader gemessen wird, auf den elektrischen Widerstand der entsprechend kontaktierten Ader zu schließen.

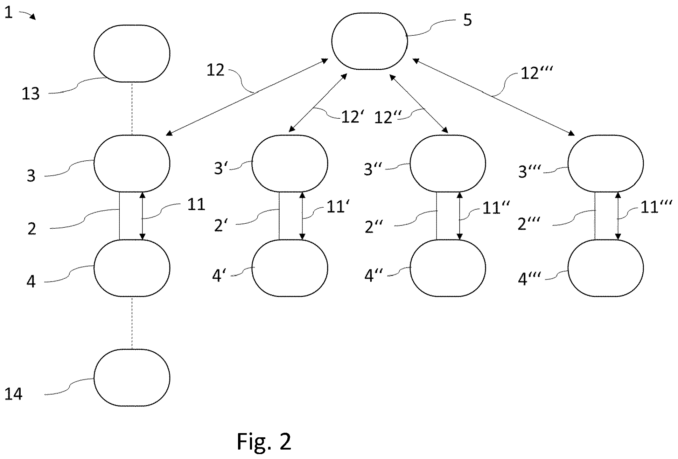

Figur 2 zeigt eine Verbindungskonfiguration eines Messsystems 1, welches entsprechend der in Figur 1 gezeigten Ausführungsform ausgestaltet ist, sodass für identische Merkmale entsprechend identische Bezugszeichen verwendet sind. So sind zwei Datenerfassungseinheiten 3, 4, über ein mehradriges Kabel 2 miteinander verbunden. Die Datenerfassungseinheiten 3, 4 sind, wie ebenfalls in Verbindung zu Figur 1 erläutert, in die endseitigen Anschlüsse des Kabels 2 integriert, mittels derer zwei elektrische Komponenten 13 und 14 miteinander verbunden sind. In dem hier gezeigten Fall handelt es sich bei Komponente 13 um eine elektrische Steuerung und bei Komponente 14 um einen Sensor, die mittels der elektrischen Steuerung gesteuert wird und diese gleichzeitig mit elektrischer Energie versorgt. Wie anhand von Figur 2 erkennbar ist, sind die Datenerfassungseinheiten 3 und 4 über die Peripheral-Verbindung 11 drahtlos miteinander verbunden. Gleichzeitig ist die Datenerfassungseinheit 3 über eine einzige Central-Verbindung 12 drahtlos mit der zentralen Verarbeitungseinheit 5 verbunden.

Wie anhand von Figur 2 ebenfalls erkennbar ist, wird eine Mehrzahl mehradriger Leitungen 2', 2", 2‴ etc. jeweils mittels eines Paars von Datenerfassungseinheiten 3', 4' bzw. 3",4" bzw. 3‴,4‴ überwacht. Hierbei dienen die drahtlosen Peripheral-Verbindungen 11', 11", 11‴ dazu, die jeweils erfassten Messgrößen zwischen den Datenerfassungseinheiten 3', 4' bzw. 3",4" bzw. 3‴,4‴ zu übertragen. Die Central-Verbindungen 12', 12", 12‴ bestehen jeweils zwischen einer der Datenerfassungseinheiten 3', 3", 3‴ und der gemeinsamen zentralen Verarbeitungseinheit 5. Wie oben geschildert, ist es ein Vorteil, dass die Anzahl an Central-Verbindungen 12, 12', 12", 12‴ höher ist als es bei herkömmlichen Verbindungskonfigurationen möglich wäre.

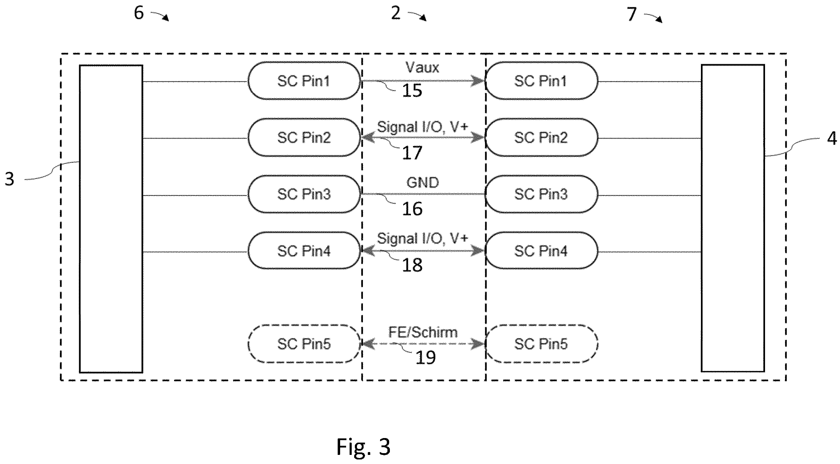

Figur 3 zeigt einen schematischen Pin-Belegungsplan der endseitigen Anschlüsse 6, 7, die jeweils mit den Adern 15, 16, 17 und 18 der Leitung 2 verbunden sind und in welche die Datenerfassungseinheiten 3, 4 integriert sind.

Die Anschlüsse 6 und 7 weisen jeweils fünf identisch benannte Pins "SC Pin1", "SC Pin2", "SC Pin3", "SC Pin4" und "SC Pin5" auf, die einander zugeordnet sind. Das Kabel 2 weist vier Adern 15, 16, 17 und 18 auf, die über die Pins "SC Pin1", "SC Pin2", "SC Pin3", "SC Pin4" der Anschlüsse 6 und 7 miteinander elektrisch verbunden sind.

Bei Ader 15 handelt es sich um Versorgungsader, bei Ader 16 um eine Bezugspotentialader und bei den Adern 17 und 18 jeweils um Signaladern. Ferner umfasst das Kabel einen Schirm 19, welcher ebenfalls über die Anschlüsse 6 und 7 elektrisch kontaktiert ist und dazu dient, die elektrischen Signale innerhalb des Kabels vor äußeren Störeinflüssen abzuschirmen und gleichzeitig zu verhindern, dass andere Geräte oder Systeme durch den aktiven Zustand des Kabels 2 beeinflusst werden.

Anhand von Figur 3 ist erkennbar, dass die Datenerfassungseinrichtungen 3, 4 mit den Adern 15, 16, 17 und 18 kontaktiert sind und in oben bereits beschriebener Weise dazu dienen, anhand der elektrischen Spannungen sowie anhand des elektrischen Stromes der jeweiligen Ader eine zwischen den Adern 15, 16, 17 und 18 eine elektrische Eigenschaft des Kabels 2 zu ermitteln. Wie in Zusammenhang mit Figur 1 bereits beschrieben, lässt sich durch Differenzbildung zwischen den gemessenen Spannungen an den Anschlüssen 6 und 7 und Messung des anliegenden Stroms ein Rückschluss auf den ohmschen Widerstand mindestens einer der Adern 15, 16, 17, 18 ziehen.

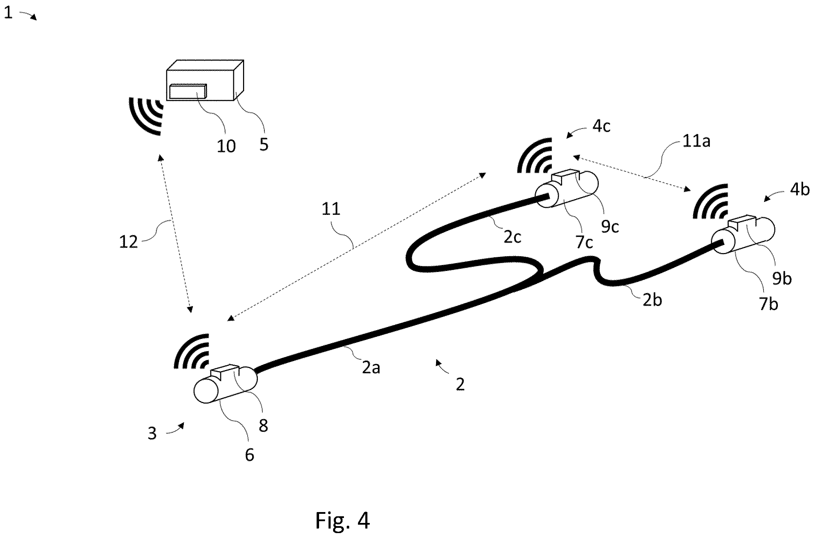

Figur 4 zeigt ein weiteres Ausführungsbeispiel eines Messsystems 1, welches insgesamt drei Datenerfassungseinheiten 3, 4b, 4c und die zentrale Verarbeitungseinheit 5 aufweist. Die Datenerfassungseinheiten 3, 4b, 4c sind jeweils in die endseitigen Anschlüsse 6 bzw. 7b bzw. 7c eines Y-Kabels integriert und dienen dazu, dieses zu charakterisieren. Das Y-Kabel weist in an sich bekannter Weise einen Stammabschnitt 2a und zwei Astabschnitte 2b, 2b auf. Entsprechend der Ausführungen in Verbindung mit Figur 3, weist der Stammabschnitt insgesamt vier Adern und einen Schirm auf, die jeweils auf die Astabschnitte 2b, 2c aufgeteilt werden. In anderen Worten weisen die Astabschnitte 2b und 2c ebenfalls jeweils vier Adern und einen Schirm auf, die mit den vier Adern und dem Schirm des Stammabschnittes 2a verbunden sind.

Die Datenerfassungseinheiten 3, 4b, 4c dienen jeweils dazu, um in einem aktiven Zustand des Y-Kabels eine elektrische Spannung an den endseitigen Anschlüssen 6, 7b, 7c zu erfassen. Die Datenerfassungseinheiten 3, 4b, 4c umfassen hierbei, entsprechend den Ausführungen zu Figur 1, jeweils ein Kommunikationsmodul 8, 9b, 9c. Die Kommunikationsmodule 8, 9b, 9c sind dafür vorgesehen, um zwei drahtlose Peripheral-Verbindungen 11 und 11a zwischen den Datenerfassungseinheiten 3, 4b, 4c herzustellen, wobei die Peripheral-Verbindung 11 zwischen den Datenerfassungseinheiten 3 und 4c besteht und die Peripheral-Verbindung 11a zwischen den Datenerfassungseinheiten 4b und 4c besteht. Alternativ kann die Periperal-Verbindung 11a auch zwischen den Datenerfassungseinheiten 3 und 4b bestehen. Das Kommunikationsmodul 8 der Datenerfassungseinheit 3 ist auch dazu ausgebildet, um eine einzige drahtlose Central-Verbindung 12 zu dem Kommunikationsmodul 10 der zentralen Verarbeitungseinheit 5 aufzubauen.

Es ist ein Vorteil, dass auch für die Charakterisierung des Y-Kabels lediglich eine Central-Verbindung 12 zwischen einer der drei Datenerfassungseinheiten 3, 4b, 4c und der zentralen Verarbeitungseinheit 5 erforderlich ist. Gemäß der in Figur 5 gezeigten Verbindungskonfiguration ist die Datenerfassungseinheit 3 über die einzige Central-Verbindung 12 mit der zentralen Verarbeitungseinheit 5 und gleichzeitig über die Peripheral-Verbindung 11 mit einer der Datenerfassungseinheit 4c verbunden. Alternativ könnte die Datenerfassungseinheit 3 ebenfalls über die Central-Verbindung 12 mit der zentralen Verarbeitungseinheit 5 verbunden sein und gleichzeitig über zwei Peripheral-Verbindungen mit den Datenerfassungseinheiten 4b und 4c.

## Patentansprüche

1. Messsystem (1) zur Charakterisierung eines mehradrigen Kabels (2), welches mindestens zwei Datenerfassungseinheiten (3, 4, 4b, 4c) und eine zentrale Verarbeitungseinheit (5) umfasst,
wobei die zwei Datenerfassungseinheiten (3, 4, 4b, 4c) jeweils dazu vorgesehen sind, um an einem endseitigen Anschluss (6, 7, 7b, 7c) mit dem Kabel (2) kontaktiert zu werden und dazu ausgebildet sind, zumindest in einem aktiven Zustand des Kabels (2), jeweils eine elektrische Messgröße an den endseitigen Anschlüssen (6, 7, 7b, 7c) zu erfassen,
und bei dem die Datenerfassungseinheiten (3, 4, 4b, 4c) und die zentrale Verarbeitungseinheit (5) jeweils ein Kommunikationsmodul (8, 9, 10) umfassen, wobei
die Kommunikationsmodule (8, 9, 9b, 9c) der Datenerfassungseinheiten (3, 4, 4b, 4c) dafür vorgesehen sind, um eine drahtlose Peripheral-Verbindung (11) zwischen den Datenerfassungseinheiten (3, 4, 4b, 4c) aufzubauen, um die jeweils erfasste Messgröße von einer der Datenerfassungseinheiten (3, 4, 4b, 4c) an die jeweils andere Datenerfassungseinheit (3, 4, 4b, 4c) zu übermitteln, und wobei
das Kommunikationsmodul (8, 9, 9b, 9c) zumindest einer der Datenerfassungseinheiten (3, 4, 4b, 4c) und das Kommunikationsmodul (10) der zentralen Verarbeitungseinheit (5) dafür vorgesehen sind, um eine einzige drahtlose Central-Verbindung (12) zwischen einer der beiden Datenerfassungseinheiten (3, 4, 4b, 4c) und der zentralen Verarbeitungseinheit (5) aufzubauen, um zumindest eine der erfassten Messgrößen und/oder eine davon abhängige Größe an die zentrale Verarbeitungseinheit (5) zu übermitteln.

2. Messsystem (1) nach Anspruch 1, bei dem
die Kommunikationsmodule (8, 9, 9b, 9c, 10) der Datenerfassungseinheiten (3, 4, 4b, 4c) und der zentralen Verarbeitungseinheit (5) jeweils Bluetooth-Module sind, insbesondere Bluetooth-Low-Energy-Module.

3. Messsystem (1) nach Anspruch 1 oder 2, bei dem
die Datenerfassungseinheiten (3, 4, 4b, 4c) jeweils in einem der endseitigen Anschlüsse (6, 7, 7b, 7c) integriert sind und die Anschlüsse (6, 7, 7b, 7c) dafür vorgesehen sind, um mit zumindest zwei, vorzugsweise zumindest drei, insbesondere zumindest vier Adern des Kabels (2) verbunden zu werden.

4. Messsystem nach Anspruch 3, bei dem
einer der endseitigen Anschlüsse (3, 4, 4b, 4c) einen Stecker umfasst und der jeweils andere endseitige Anschluss eine Buchse umfasst.

5. Messsystem (1) nach Anspruch 3 oder 4, bei dem
die Datenerfassungseinheiten (3, 4, 4b, 4c) jeweils dazu ausgestaltet sind, um mit einer Versorgungsader (15) und/oder Signalader (17, 18) und einer Bezugspotentialader (16) des Kabels (2) elektrisch kontaktiert zu werden, und eine Stromstärke in der Versorgungsader (15) und/oder der Signalader (17, 18) und/oder der Bezugspotentialader (16) und/oder eine Spannung zwischen der Versorgungsader (15) und/oder der Signalader (17, 18) und der Bezugspotentialader (16) zu messen.

6. Messsystem (1) nach einem der Ansprüche 3 bis 5, bei dem
die Datenerfassungseinheiten (3, 4, 4b, 4c) jeweils dazu ausgestaltet sind, um mit einer Signalader (17, 18) elektrisch kontaktiert zu werden und eine Signalcharakteristik in der Signalader (17, 18), insbesondere eines Bus-Signals, zu erfassen.

7. Messsystem (1) nach einem der voranstehenden Ansprüche, bei dem
Die Datenerfassungseinheiten (3, 4, 4b, 4c) und/oder die zentrale Verarbeitungseinheit (5) jeweils ein Speichermodul aufweisen, auf welchem eine Identifikationskennung, insbesondere eine Media-Access-Control (MAC)-ID, gespeichert ist, und über welche die Datenerfassungseinheiten für die drahtlose Peripheral-Verbindung (11) einander zugeordnet sind und/oder über welche zumindest eine der Datenerfassungseinheiten (3, 4, 4b, 4c) der zentralen Verarbeitungseinheit (5) für die drahtlose Central-Verbindung (12) zugeordnet ist.

8. Messsystem (1) nach einem der voranstehenden Ansprüche, bei dem
zumindest eine der Datenerfassungseinheiten (3, 4, 4b, 4c), welche insbesondere dazu ausgestaltet ist, um mit der zentralen Verarbeitungseinheit (5) zu kommunizieren, ein Auswertungsmodul aufweist, welches dazu eingerichtet ist, um die an den beiden endseitigen Anschlüssen (3, 4, 4b, 4c) erfassten Messgrößen zu verarbeiten und eine davon abhängige Größe an die zentrale Verarbeitungseinheit (5) zu übermitteln.

9. Messsystem (1) zumindest nach Anspruch 8, bei dem
die von den Messgrößen abhängige Größe eine Differenz und/oder ein Quotient zwischen den gemessenen Messgrößen an den Anschlüssen (3, 4, 4b, 4c) umfasst.

10. Messsystem (1) zumindest nach Anspruch 8, bei dem
die von den Messgrößen abhängige Größe einen zeitlichen Verlauf zumindest einer der Messgrößen umfasst.

11. Messsystem (1) zumindest nach Anspruch 8, bei dem
die von den Messgrößen abhängige Größe eine Kabelimpedanz und/oder eine Signallaufzeit in dem aktiven Zustand des Kabels umfasst.

12. Messsystem (1) nach einem der voranstehenden Ansprüche, mit zumindest drei Datenerfassungseinheiten (3, 4, 4b, 4c), die jeweils dafür vorgesehen sind, um an den endseitigen Anschlüssen (6, 7, 7b, 7c) eines mehradrigen Y-Kabels (2) kontaktiert zu werden, und welche jeweils dazu ausgebildet sind, um zumindest in einem aktiven Zustand des Y-Kabels (2) eine elektrische Messgröße an einem der endseitigen Anschlüsse (6, 7b, 7c) zu erfassen, wobei
die Datenerfassungseinheiten (3, 4, 4b, 4c) jeweils ein Kommunikationsmodul (8, 9b, 9c) umfassen, wobei die Kommunikationsmodule (8, 9b, 9c) jeweils dafür vorgesehen sind, um zwei drahtlose Peripheral-Verbindungen (11, 11a) zwischen jeweils zwei der drei Datenerfassungseinheiten (3, 4, 4b, 4c) aufzubauen, wobei
das Kommunikationsmodul (8, 9, 9b, 9c) einer der Datenerfassungseinheiten (3, 4b, 4c) auch dazu ausgebildet ist, um die einzige drahtlose Central-Verbindung (12) mit einem Kommunikationsmodul (10) einer zentralen Verarbeitungseinheit (5) aufzubauen, um zumindest eine der erfassten Messgrößen an die zentrale Verarbeitungseinheit (5) zu übermitteln.

13. Verfahren zur Charakterisierung eines mehradrigen Kabels (2), umfassend die folgenden Verfahrensschritte:
A) Bereitstellen eines Messsystems (1) nach einem der Ansprüche 1 bis 12;
B) Elektrisches Kontaktieren von mindestens zwei Datenerfassungseinheiten (3, 4, 4b, 4c) mit dem Kabel (2) über jeweils einen endseitigen Anschluss (6, 7, 7b, 7c);
C) Anlegen einer elektrischen Spannung an das Kabel (2);
D) Aufbauen einer drahtlosen Peripheral-Verbindung (11, 11a) zwischen den Datenerfassungseinheiten (3, 4, 4b, 4c) des Messsystems;
E) Aufbauen einer einzigen drahtlosen Central-Verbindung (12) zwischen der zentralen Verarbeitungseinheit (5) und einer der zwei Datenerfassungseinheiten (3, 4, 4b, 4c);
F) Erfassen zumindest zweier elektrischer Messgrößen an den Anschlüssen (6, 7, 7b, 7c);
G) Übermitteln zumindest einer der erfassten Messgrößen zwischen den Datenerfassungseinheiten (3, 4, 4b, 4c);
H) Übertragen zumindest einer der erfassten Messgrößen und/oder einer davon abhängigen Größe von nur einer der Datenerfassungseinheiten (3, 4, 4b, 4c) an die zentrale Verarbeitungseinheit (5).

14. Verfahren nach Anspruch 13, bei dem
Verfahrensschritt D) ein Advertising zwischen den Kommunikationsmodulen (8, 9, 9b, 9c) der Datenerfassungseinheiten (3, 4, 4b, 4c) umfasst.

15. Verfahren nach Anspruch 14, bei dem
nach Verfahrensschritt D) eine der mindestens zwei Datenerfassungseinheiten (3, 4, 4b, 4c) ein Advertising-Zeitfenster an die jeweils andere der beiden Datenerfassungseinheit (3, 4, 4b, 4c) gibt und bei einem Verbindungsabbruch der Central-Verbindung (12) und bei Überschreitung des Advertising-Zeitfensters die zentrale Verarbeitungseinheit (5) eine drahtlose Central-Verbindung (12) mit der jeweils anderen Datenerfassungseinheit (3, 4, 4b, 4c) aufbaut.

16. Verfahren nach einem der Ansprüche 13 bis 15, bei dem
vor Verfahrensschritt E) die mindestens zwei Datenerfassungseinheiten (3, 4, 4b, 4c) einen Token so lange austauschen, bis die zentrale Verarbeitungseinheit (5) eine Central-Verbindung (12) mit einer der Datenerfassungseinheiten (3, 4, 4b, 4c) aufgebaut hat.

17. Verfahren nach einem der Ansprüche 13 bis 16, bei dem
vor Verfahrensschritt E) ein Advertising zwischen mindestens einem der Kommunikationsmodule der Datenerfassungseinheiten (3, 4, 4b, 4c) und dem Kommunikationsmodul der zentralen Verarbeitungseinheit stattfindet.

18. Verfahren nach Anspruch 16 oder 17, bei dem
mittels der zentralen Verarbeitungseinheit mindestens einer der beiden Datenerfassungseinheiten (3, 4, 4b, 4c) ein Received Signal Strength Indicator (RSSI)-Wert zugeordnet und gespeichert wird.

19. Verfahren zumindest nach Anspruch 17, bei dem
mittels der zentralen Verarbeitungseinheit den beiden Datenerfassungseinheiten (3, 4, 4b, 4c) jeweils ein Received Signal Strength Indicator (RSSI)-Wert zugeordnet und speichert und die Central-Verbindung (12) zwischen der zentralen Verarbeitungseinheit (5) und derjenigen Datenerfassungseinheit (3, 4, 4b, 4c) aufgebaut, welcher der höhere Received Signal Strength Indicator (RSSI)-Wert zugeordnet ist.
